# EUROPEAN PATENT SPECIFICATION

(11) **EP 2 540 796 B1**
(45) Date of publication and mention of the grant of the patent: **24.01.2018**
(21) Application number: 11747269.6
(22) Date of filing: 19.02.2011
(51) Int. Cl.: C09K 11/64, C09K 11/08, H01L 33/50, C09K 11/77

(54) **ß-SIALON PHOSPHOR, USES THEREOF, PROCESS FOR PRODUCTION OF ß-SIALON PHOSPHOR**
ß-SIALON-PHOSPHOR, VERWENDUNGEN DAVON, VERFAHREN ZUR HERSTELLUNG VON ß-SIALON-PHOSPHOR
LUMINOPHORE ß-SIALON, SES UTILISATIONS, PROCÉDÉ DE FABRICATION DU LUMINOPHORE ß-SIALON

(30) Priority: 25.02.2010 JP 2010040525
(43) Date of publication of application: 02.01.2013
(73) Proprietor: Denka Company Limited, Tokyo 103-8338 (JP)
(72) Inventor: EMOTO Hideyuki, Machida-city Tokyo 194-8560 (JP); NAGASAKI Hironori, Machida-city Tokyo 194-8560 (JP)
(74) Representative: Gulde & Partner
(86) International application number: PCT/JP2011/053580
(87) International publication number: WO 2011/105305

(56) References cited:
- EP-A1- 1 884 552
- EP-A1- 2 093 272
- WO-A1-2008/062781
- JP-A- 2005 272 486
- JP-A- 2007 262 417
- JP-A- 2008 127 547
- JP-A- 2009 256 427
- US-A1- 2007 108 896
- US-A1- 2008 258 602
- HIROSAKI NAOTO ET AL: "Characterization and properties of green-emitting[beta]-SiAlON:Eu2+ powder phosphors for white light-emitting diodes", APPLIED PHYSICS LETTERS, AMERICAN INSTITUTE OF PHYSICS, US, vol. 86, no. 21, 17 May 2005 (2005-05-17), pages 211905-211905, XP012065627, ISSN: 0003-6951, DOI: 10.1063/1.1935027

## Description

### Technical Field

The present invention relates to a β-SiAlON phosphor, a luminescent material using the β-SiAlON phosphor, a light-emitting apparatus using the luminescent material, and a method of producing the β-SiAlON phosphor.

### Background Art

As technologies concerning β-SiAlON phosphors, those disclosed in Patent Literatures 1 to 5 are known.

Patent Literature 5 discloses a β-SiAlON phosphor, comprising a β-SiAlON represented by general formula Si_{6-z}Al_{z}O_{z}N_{8-z} (0.24 ≤ z ≤ 4.2) as a matrix; and Eu²⁺ dissolved therein in a form of a solid solution as an emission center, the β-SiAlON phosphor exhibiting a fluorescent peak wavelength from 520 to 560 nm when excited with blue light.

Patent Literature 6 discloses a method of producing a beta-SiAlON phosphor comprising a baking process of baking a raw material powder mixture containing Si, Al, and Eu in a nitrogen atmosphere at 1950°C; a heating process of heating the mixture having undergone the baking process in a noble gas atmosphere at 1450°C; a cooling process of cooling the mixture having undergone the heating process; and, an acid treatment process.

### Citation List

### Patent Literature

Patent Literature 1: JP 3921545 B
Patent Literature 2: WO 2006/121083
Patent Literature 3: WO 2007/142289
Patent Literature 4: WO 2008/062781
Patent Literature 5: EP 1 884 552 A1
Patent Literature 6: EPZ 093 272

### Summary of Invention

### Technical Problem

To further increase the brightness of white light-emitting diodes, improvement of luminous efficiency (external quantum efficiency) of β-SiAlON phosphors is desired.
The objective of the present invention is to provide a β-SiAlON phosphor exhibiting improved luminous efficiency, a luminescent material using the β-SiAlON phosphor, a light-emitting apparatus using the luminescent material, and a method of producing the β-SiAlON phosphor.

### Solution to Problem

The present invention provides a method of producing a β-SiAlON phosphor, comprising a β-SiAlON represented by general formula Si_{6-z}Al_{z}O_{z}N_{8-z} (0<z<4.2) as a matrix, and Eu²⁺ dissolved therein in a form of a solid solution as an emission center, the β-SiAlON phosphor exhibiting a fluorescent peak wavelength from 520 to 560 nm when excited with blue light, an average diffuse reflectance in the wavelength range from 700 to 800 nm of 90% or higher, and a diffuse reflectance at the fluorescent peak wavelength of 85% or higher, the method comprising:
a baking process of baking a raw material powder mixture containing Si, Al, and Eu in a nitrogen atmosphere at temperatures from 1850 to 2050°C;
a heating process of heating the mixture having undergone the baking process in a noble gas atmosphere at temperatures from 1300 to 1550°C;
a cooling process of cooling the mixture having undergone the heating process at temperatures from 1200 to 1000°C for 20 minutes or longer; and
an acid treatment process.

Another objective of the present invention is to provide a β-SiAlON phosphor produced by the method set forth above and containing a β-SiAlON represented by a general formula Si_{6-z}Al_{z}O_{z}N_{8-z} (0<z<4.2) as a matrix, with Eu²⁺ dissolved in a form of a solid solution as an emission center, the β-SiAlON phosphor exhibiting a peak within a wavelength range from 520 to 560 nm when excited with blue light, wherein the average diffuse reflectance in the wavelength range from 700 to 800 nm is 90% or higher, and the diffuse reflectance in the fluorescent peak wavelength is 85% or higher.

The Eu content in the β-SiAlON phosphor preferably is 0.1 to 2% by mass.

The luminescent material of the present invention includes a light-emitting device, one or more types of β-SiAlON phosphor that absorbs light emitted from the light-emitting device and emits light having a wavelength longer than that of the light emitted from the light-emitting device, and a sealing material containing the β-SiAlON phosphors, wherein the β-SiAlON phosphors being the β-SiAlON phosphor described above.

Another objective of the present invention is to provide a light-emitting apparatus using this luminescent material.

### Advantageous Effect of Invention

According to the structure of the present invention described above, a β-SiAlON phosphor with decreased non-luminous absorption in a fluorescent emission wavelength range, improved internal quantum efficiency and increased luminous efficiency was obtained.

Since the luminescent material and the light-emitting apparatus, which are other objectives of the present invention, use the above-mentioned β-SiAlON phosphor, a β-SiAlON phosphor exhibiting high emission property was produced.

### Brief Description of Drawings

FIG. 1 is a cross-sectional view illustrating the structure of a light-emitting apparatus according to the present invention.
FIG. 2 is a chart showing diffuse reflectance spectra in the wavelength range from 500 to 850 nm in Examples and Comparative Examples.

### Description of Embodiments

The embodiments of the present invention will hereinafter be described in detail.

The present invention provides a β-SiAlON phosphor containing a β-SiAlON represented by a general formula Si_{6-z}Al_{z}O_{z}N_{8-z} (0<z<4.2) as a matrix, with Eu²⁺ dissolved in a form of a solid solution as an emission center, the β-SiAlON phosphor exhibiting a fluorescent peak wavelength from 520 to 560 nm when excited with blue light, wherein the average diffuse reflectance in the wavelength range from 700 to 800 nm is 90% or higher, and the diffuse reflectance at the fluorescent peak wavelength is 85% or higher.

With the present invention, the average diffuse reflectance in the wavelength range from 700 to 800 nm was set to 90% or higher to increase the transparency of the matrix, thereby improving the internal quantum efficiency. Fluorescent emission of Eu²⁺ of the Eu²⁺-doped β-SiAlON phosphor occurs within a wavelength range from 500 to 700 nm. In other words, diffuse reflectance in a wavelength range exceeding 700 nm is a value representing absorption by substances other than Eu²⁺ in the β-SiAlON, namely the value representing absorption not involving the emission of the matrix material. By performing averaging within the wavelength range from 700 to 800 nm, this diffuse reflectance can be assessed with high reproducibility. To control the β-SiAlON phosphor to fall within this range, it is only necessary to increase the crystallinity of the β-SiAlON or decrease impurities that absorb visible light and a second phase (crystals other than the β-SiAlON).

The diffuse reflectance in the fluorescent peak wavelength in the present invention was set to 85% or higher to remove crystal defect in proximity to Eu²⁺ within the β-SiAlON crystal. This crystal defect traps Eu²⁺-excited electrons, thus suppressing luminescence. This behavior is reflected on the reflectance within the emission wavelength range. In particular, the diffuse reflectance in fluorescent peak wavelength exhibits close relation with fluorescent property. To control the β-SiAlON phosphor to fall within this range, it is only necessary to decrease crystal defect, which traps electrons excited by Eu²⁺.

The Eu content in the β-SiAlON phosphor preferably is from 0.1 to 2% by mass. Too low Eu content tends to inhibit sufficient fluorescent emission from occurring, whereas too high Eu content tends to cause decrease in fluorescent emission due to concentration quenching.

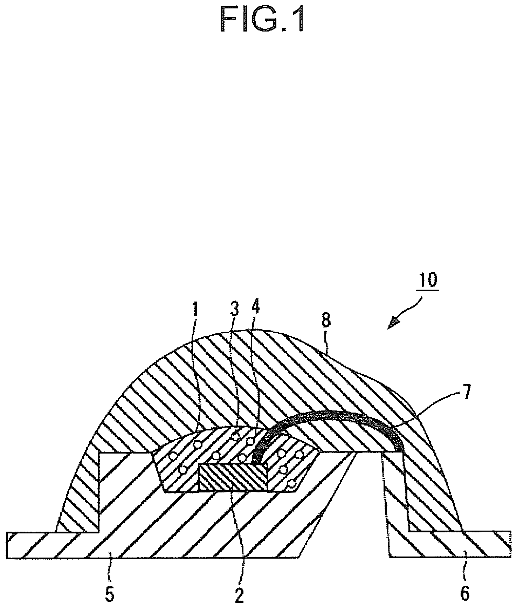

As shown in FIG. 1, the luminescent material 1, namely another objective of the present invention, includes: a light-emitting device 2; one or more types of β-SiAlON phosphor 3 that absorbs the light emitted from the light emitting device and emits light having a wavelength longer than that of the light emitted from the light-emitting device; and a sealing material 4 containing the β-SiAlON phosphors, wherein the β-SiAlON phosphor 3 according to the present invention described above is used as the β-SiAlON phosphors. FIG. 1 illustrates a light-emitting apparatus 10 integrating this luminescent material 1.

Since the luminescent material 1 according to the present invention uses the β-SiAlON phosphor 3 described above, decrease in brightness is small even if it is used at high temperatures, and it provides long service life and high brightness.

Another objective of the present invention is to provide a light-emitting apparatus using this luminescent material. As shown in FIG. 1, this light-emitting apparatus 10 includes: a luminescent material 1 made up of a sealing material 4 that contains the β-SiAlON phosphor 3 and covers a light-emitting device 2; a first lead frame 5 to which the light-emitting device 2 is mounted; a second lead frame 6; a bonding wire 7 for electrically connecting the light-emitting device 2 and the second lead frame 6; and a resin or glass cap 8 that covers all of the sealing material 4, the first and the second lead frames 5, 6, and the bonding wire 7.

When using this light-emitting apparatus 10 as a light-emitting diode, for example, fluctuation in brightness and color is minimized and long life is ensured because the β-SiAlON phosphors described above are used.

Yet another objective of the present invention is to provide a method of producing the β-SiAlON phosphor. Specifically, the method of producing the β-SiAlON phosphor according to the present invention includes: a baking process of baking a raw material powder mixture containing Si, Al, and Eu in a nitrogen atmosphere at temperatures from 1850 to 2050°C; a heating process of heating the mixture having undergone the baking process in a noble gas atmosphere at temperatures from 1300 to 1550°C; a cooling process of cooling the mixture having undergone the heating process at temperatures from 1200 to 1000°C for 20 minutes or longer; and an acid treatment process.

According to the present invention, by performing cooling after the heat treatment process at temperatures falling within the range from 1200 to 1000°C for 20 minutes or longer, crystal defect in proximity to Eu²⁺ in the β-SiAlON crystal is removed, and thus non-radiative transition due to trapping of excited electrons can be decreased.

Regarding the cooling temperature after the heating process, it is essential to place the temperature range from 1200 to 1000°C only under time control. Time control for a range exceeding 1200°C and below 1000°C is also allowed, and can be selected as required with productivity taken into consideration depending on the baking furnace used.

If the duration of cooling within the temperature range from 1200 to 1000°C at the cooling after the heating process is too short, crystal defect tends not to be removed as intended. Therefore, the duration should be 20 minutes or longer, preferably 60 minutes or longer, and more preferably 90 minutes or longer but not exceeding 130 minutes. Even if cooling is performed longer, the fluorescent property levels off.

### Example

The present invention will hereinafter be described in detail by referring to Examples and Comparative Examples.

### (Comparative Example 1)

Powder α-silicon nitride manufactured by Ube Industries, Ltd. (grade SN-E10, oxygen content: 1.2% by mass), powder aluminum nitride manufactured by Tokuyama Corporation (grade F, oxygen content: 0.8% by mass), powder aluminum oxide manufactured by Sumitomo Chemical Co., Ltd. (grade AKP-30), and powder europium manufactured by Shin-Etsu Chemical Co., Ltd. (grade RU) were mixed in percentage of 95.64%, 3.35%, 0.18%, and 0.84% by mass respectively to obtain raw material mixture.

The compounding ratio of raw materials except for europium oxide in Comparative Example 1 represented by general formula of β-SiAlON, Si_{6-z}Al_{z}O_{z}N_{8-z}, allows z to be 0.24, assuming that impurity oxygen in powder silicon nitride and that in powder aluminum nitride are respectively silicon dioxide and aluminum oxide.

The above raw material mixture was further mixed using a V-type mixer ("S-3," Tsutsui Scientific Instruments Co., Ltd.), and the mixture was then sieved with a 250 µm sieve thoroughly to remove agglomerate and obtain raw material powder mixture.

This raw material powder mixture was packed in a lidded cylindrical container made of boron nitride (grade N-1, Denki Kagaku Kogyo Kabushiki Kaisha), and heat treatment was performed in a carbon-heater electric furnace in pressurized nitrogen atmosphere of 0.9 MPa at 2000°C for 10 hours. The obtained compound was green and in a massive structure. This massive structure was crushed using an alumina mortar until the entire volume passed through a 150 µm sieve, then classification was performed using a 45 µm sieve, and the powder having passed the sieve was used as Eu²⁺-doped β-SiAlON powder in Comparative Example 1.

The powder mixture in Comparative Example 1 was subjected to powder X-ray diffractometry (XRD) using Cu-Kα ray, and the β-SiAlON was found to constitute a major crystalline phase, and a plurality of diffraction lines were found in the vicinity of 2θ = 33 to 38°. The plurality of these diffraction lines exhibited intensity as low as 1% or less of the diffraction line intensity on 101 surface of the β-SiAlON. The Eu content found by ICP emission spectral analytical method was 0.62% by mass.

The emission spectrum of the β-SiAlON phosphor was assessed as follows. A recessed cell was filled with the β-SiAlON phosphor powder in order that the surface of the cell became even, and an integrating sphere was mounted. To the integrating sphere, monochromatic light dispersed from an emission source (Xe lamp) to have wavelength of 455 nm was introduced using an optical fiber. The monochromatic light was irradiated to the β-SiAlON phosphor sample as an excitation source, and the fluorescence spectrum of the sample was measured using a spectrophotometer (MCPD-7000, Otsuka Electronics Co., Ltd.) to find the fluorescent peak wavelength, which was found to be 541 nm.

The luminous efficiency of the β-SiAlON phosphor was assessed as follows using the same measuring instrument.
A standard reflector (Spectralon, Labsphere, Inc.) having the reflectance of 99% was set to the sample unit, and the spectrum of the excitation light having wavelength of 455 nm was measured. At that time, the photon count of the excitation light (Qₑₓ) was calculated from the spectrum within the wavelength range from 450 to 465 nm. The β-SiAlON phosphor was then set to the sample unit, and the photon count of the reflected light (Q_{ref}) and the photon count of the fluorescent light (Qₑₘ) were found from the obtained spectrum data. The photon count of the reflected light was calculated within the same wavelength range as the photon count of the excitation light, and the photon count of the fluorescent light was calculated within the range from 465 to 800 nm. From the three photon counts obtained, external quantum efficiency (=Qₑₘ/Qₑₓ×100), absorptance (=(Qₑₓ-Q_{ref})×100), and internal quantum efficiency (= Qₑₘ/(Qₑₓ-Q_{ref})×100) were found. They were respectively 30.9%, 69.5%, and 44.5% when excited with blue light having wavelength of 455 nm.

The diffuse reflectance of the β-SiAlON phosphor powder was measured using an ultraviolet-visible spectrophotometer (V-550, JASCO Corporation) equipped with an integrating sphere unit (ISV-469). Baseline correction was conducted using a standard reflector (Spectralon), a solid sample holder filled with the β-SiAlON phosphor powder sample was set, and diffuse reflectance was measured in the wavelength range from 500 to 850 nm. The diffuse reflectance at fluorescent peak wavelength and the average diffuse reflectance within the wavelength range from 700 to 800 nm were respectively 79.1% and 89.5%.

### (Example 1)

The β-SiAlON phosphor in Comparative Example 1 was packed in a lidded cylindrical vessel made of boron nitride (grade N-1, Denki Kagaku Kogyo Kabushiki Kaisha), heat treatment was performed in a carbon-heater electric furnace in an argon atmosphere at atmospheric pressure at 1500°C for 7 hours and cooling was performed under the following conditions: cooling rates from 1450°C to 1200°C; 10°C/min., from 1200°C to 500°C; 1°C/min., and 500°C and lower; furnace cooling (approximately one hour to reach room temperature). The time required to decrease from 1200°C to 1000°C; in the cooling process was 200 minutes. Furthermore, the obtained heat treated powder was subjected to heat treatment in 1:1 mixed acid of a 50% hydrofluoric acid solution and a 70% nitric acid solution at 75°C, cooling was performed, and then decantation, namely the process of leaving the solution as it was, removing supernatant, adding distilled water and agitating the solution, leaving the solution as it was, and removing the supernatant again, was repeated until the pH of the suspended liquid became neutral. Then filtration and drying were performed to obtain β-SiAlON phosphor powder.

As a result of XRD measurement performed, the β-SiAlON phosphor powder in Example 1 was found to be single-phase β-SiAlON, and the trace amount of the second-phase peak, which was exhibited in Comparative Example 1, had disappeared. The Eu content was 0.43% by mass, which was lower than the content in Comparative Example 1.

The fluorescent peak wavelength, external quantum efficiency, absorptance, and internal quantum efficiency obtained when excited by blue light having wavelength of 455 nm were 544 nm, 54.3%, 67.3%, and 80.8% respectively. The diffuse reflectance at fluorescent peak wavelength and the average diffuse reflectance in the wavelength from 700 to 800 nm were 89.1% and 92.7% respectively.

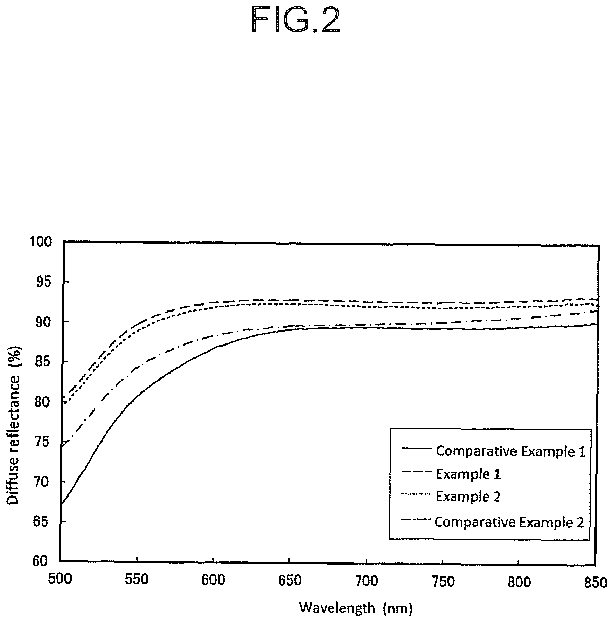

FIG. 2 shows the diffuse reflectance spectrum within the wavelength range from 500 to 850 nm in Example 1 and Comparative Example 1. By subjecting the β-SiAlON phosphor powder in Comparative Example 1 to heat treatment in an argon atmosphere, and then performing acid treatment, flat diffuse reflectance in red to near-red region increased slightly, and at the same time the diffuse reflectance in the fluorescent emission wavelength range increased. Consequently, the internal quantum efficiency, in particular, of the β-SiAlON phosphor increased and thus the luminous efficiency improved.

### (Examples 2 and 3, Comparative Examples 2 and 3)

Using the β-SiAlON phosphor powder in Comparative Example 1, heat treatment was conducted as in the case of Example 1, with cooling conditions only changed. The cooling conditions in Example 2 were as follows: cooling time for decreasing the temperature from 1200°C to 1000°C in the cooling process was 200 minutes, and in order that approximately one and a half hours were needed to reach the room temperature, the temperature was decreased from 1450°C to 1200°C at the rate of 10°C/min., and from 1200°C to 1000°C at the rate of 1°C/min. For the temperature of 1000°C and lower, furnace cooling was adopted.

The cooling conditions in Example 3 was as follows: cooling time for decreasing the temperature from 1200°C to 1000°C in the cooling process was 40 minutes, and the temperature was decreased from 1450°C to 1200°C at the rate of 10°C/min., from 1200°C to 1000°C at the rate of 5°C/min., and for the temperature of 1000°C and lower, furnace cooling was adopted. It took about one and a half hours to reach the room temperature.

The cooling conditions in Comparative Example 2 was as follows: cooling time for decreasing the temperature from 3.200°C; to 1000°C in the cooling process was 10 minutes, and the temperature was decreased from 1450°C to 1200°C at the rate of 10°C/min., from 1200°C to 1000°C at the rate of 20°C/min., and for the temperature of 1000°C and lower, furnace cooling was adopted.

The cooling conditions in Comparative Example 3 was as follows: cooling time for decreasing the temperature from 1200°C to 1000°C in the cooling process was 10 minutes, and the temperature was decreased from 1450°C; to 1200°C at the rate of 1°C/min., from 1200°C to 1000°C at the rate af 20°C/min., and for the temperature of 1000°C or lower, furnace cooling was adopted.

Table 1 lists the cooling time for decreasing the temperature from 1200°C to 1000°C in the heating process, and Eu content and fluorescent properties measured by ICP emission analysis. FIG. 2 also shows the diffuse reflectance spectra in the wavelength range from 500 to 850 nm in Examples 2 and Comparative Examples 2.

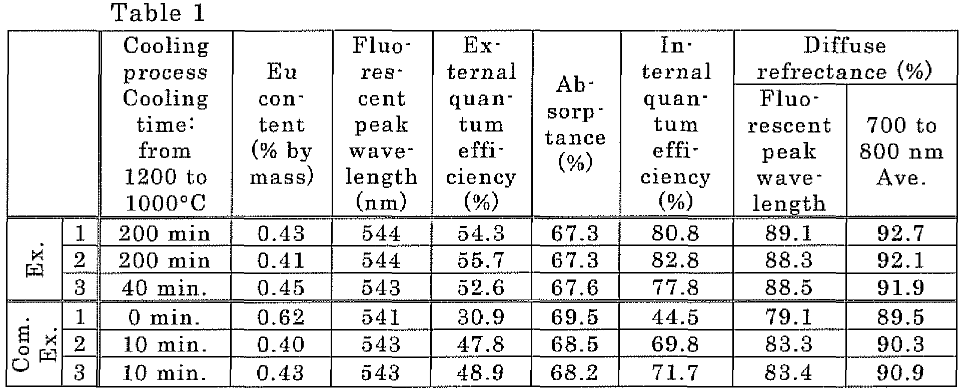

The Examples and Comparative Examples show that the rate of cooling performed after heat treatment affected the diffuse reflectance of the β-SiAlON phosphor obtained finally, and that by increasing the diffuse reflectance within the 700 to 800 nm fluorescent peak wavelength range, the internal quantum efficiency increased substantially. Regarding the rate of cooling performed after the heat treatment, by setting the duration of cooling from 1200 to 1000°C at 20 minutes or longer, the diffuse reflectance improved.

Although not listed in the table, in Example 4, where the cooling time was changed to three hours from that in Example 1, the internal quantum efficiency and diffuse reflectance exhibited similar values as Example 1.

The Example related to the luminescent material will be described below.
The luminescent material in this Example includes a light-emitting diode as a light-emitting device, β-SiAlON phosphor in Example 1 that absorbs light emitted from the light-emitting device and emits light having wavelength longer than that of the light emitted from the light-emitting device, and a sealing material containing the β-SiAlON phosphor.

This luminescent material had higher diffuse reflectance because the β-SiAlON phosphor having higher diffuse reflectance than the luminescent material using the β-SiAlON phosphor in Comparative Examples 1 to 3 was used.

The Example related to the light-emitting apparatus is described as follows: the light-emitting apparatus in this Example uses the above-mentioned luminescent material.

This light-emitting apparatus had higher diffuse reflectance because the β-SiAlON phosphor having higher diffuse reflectance than the light-emitting apparatus using the β-SiAlON phosphor in Comparative Examples 1 to 3 was used.

### Reference Sign List

- 1:: Luminescent material
- 2:: Light-emitting device
- 3:: β-SiAlON phosphor
- 4:: Sealing material
- 5:: First lead frame
- 6:: Second lead frame
- 7:: bonding wire
- 8:: Cap
- 10:: Light-emitting apparatus

## Claims

1. A method of producing a β-SiAlON phosphor, comprising a β-SiAlON represented by general formula Si_{6-z}Al_{z}O_{z}N_{8-z}, (0<z<4.2) as a matrix, and Eu²⁺ dissolved therein in a form of a solid solution as an emission center, the β-SiAlON phosphor exhibiting a fluorescent peak wavelength from 520 to 560 nm when excited with blue light, an average diffuse reflectance in the wavelength range from 700 to 800 nm of 90% or higher, and a diffuse reflectance at the fluorescent peak wavelength of 85% or higher, the method comprising:
a baking process of baking a raw material powder mixture containing Si, Al, and Eu in a nitrogen atmosphere at temperatures from 1850 to 2050°C;
a heating process of heating the mixture having undergone the baking process in a noble gas atmosphere at temperatures from 1300 to 1550°C;
a cooling process of cooling the mixture having undergone the heating process at temperatures from 1200 to 1000°C for 20 minutes or longer; and
an acid treatment process.

2. A β-SiAlON phosphor, comprising: a β-SiAlON represented by a general formula Si_{6-z}Al_{z}O_{z}N_{8-z} (0<z<4.2) as a matrix; and Eu²⁺ dissolved therein in a form of a solid solution as an emission center and produced as set forth in claim 1, the β-SiAlON phosphor exhibiting a fluorescent peak wavelength from 520 to 560 nm when excited with blue light,
wherein the average diffuse reflectance in the wavelength range from 700 to 800 nm is 90% or higher, and the diffuse reflectance at the fluorescent peak wavelength is 85% or higher.

3. The β-SiAlON phosphor as set forth in claim 2, wherein the Eu content is from 0.1 to 2% by mass.

4. The β-SiAlON phosphor as set forth in claim 2 or 3, wherein the internal quantum efficiency of the β-SiAlON phosphor is 77.8 to 82.8%.

5. The β-SiAlON phosphor as set forth in any one of claims 2 to 4, wherein the external quantum efficiency of the β-SiAlON phosphor is 52.6 to 55.7%.

6. A luminescent material, comprising: a light-emitting device; one or more types of β-SiAlON phosphor that absorbs light emitted from the light-emitting device and emits light having a wavelength longer than that of the light emitted from the light-emitting device; and a sealing material containing the β-SiAlON phosphor, wherein the β-SiAlON phosphor is the β-SiAlON phosphor as set forth in any one of claims 2 to 5.

7. A light-emitting apparatus using the luminescent material as set forth in claim 6.

## Patentansprüche

1. Verfahren zur Herstellung eines β-SiAlON-Leuchtstoffes, umfassend ein β-SiAlON, dargestellt durch die allgemeine Formel Si_{6-z}Al_{z}O_{z}N_{8-z} (0 < z < 4,2), als Matrix, und Eu²⁺, gelöst darin in Form einer festen Lösung, als Emissionszentrum, wobei der β-SiAlON-Leuchtstoff eine Fluoreszenzpeakwellenlänge von 520 bis 560 nm bei Anregung mit blauem Licht, einen mittleren diffusen Reflexionsgrad im Wellenlängenbereich von 700 bis 800 nm von 90 % oder höher und einen diffusen Reflexionsgrad bei der Fluoreszenzpeakwellenlänge von 85 % oder höher aufweist, wobei das Verfahren umfasst:
einen Brennprozess des Brennens eines Si, Al und Eu enthaltenden Ausgangsmaterialpulvergemisches in einer Stickstoffatmosphäre bei Temperaturen von 1850 bis 2050 °C;
einen Heizprozess des Heizens des Gemisches, das den Brennprozess durchlaufen hat, in einer Edelgasatmosphäre bei Temperaturen von 1300 bis 1550 °C;
einen Kühlprozess des Kühlens des Gemisches, das den Heizprozess durchlaufen hat, bei Temperaturen von 1200 bis 1000 °C über 20 Minuten oder länger; und
einen Säurebehandlungsprozess.

2. β-SiAlON-Leuchtstoff, umfassend ein β-SiAlON, dargestellt durch eine allgemeine Formel Si_{6-z}Al_{z}O_{z}N_{8-z} (0 < z < 4,2), als Matrix; und Eu²⁺, gelöst darin in Form einer festen Lösung, als Emissionszentrum, und hergestellt nach Anspruch 1, wobei der β-SiAlON-Leuchtstoff eine Fluoreszenzpeakwellenlänge von 520 bis 560 nm bei Anregung mit blauem Licht aufweist,
wobei der mittlere diffuse Reflexionsgrad im Wellenlängenbereich von 700 bis 800 nm 90 % oder höher ist, und die diffuse Reflexion bei der Fluoreszenzpeakwellenlänge 85 % oder höher ist.

3. β-SiAlON-Leuchtstoff nach Anspruch 2, wobei der Eu-Gehalt von 0,1 bis 2 Masse-% beträgt.

4. β-SiAlON-Leuchtstoff nach Anspruch 2 oder 3, wobei die interne Quanteneffizienz des β-SiAlON-Leuchtstoffes 77,8 bis 82,8 % beträgt.

5. β-SiAlON-Leuchtstoff nach einem der Ansprüche 2 bis 4, wobei die externe Quanteneffizienz des β-SiAlON-Leuchtstoffes 52,6 bis 55,7 % beträgt.

6. Lumineszierendes Material, umfassend: eine lichtemittierende Vorrichtung; einen oder mehrere Typen des β-SiAlON-Leuchtstoffes, der von der lichtemittierenden Vorrichtung emittiertes Licht absorbiert und Licht mit einer Wellenlänge, die länger als die des von der lichtemittierenden Vorrichtung emittierten Lichts ist, emittiert; und ein den β-SiAlON-Leuchtstoff enthaltendes Abdichtungsmaterial, wobei der β-SiAlON-Leuchtstoff der β-SiAlON-Leuchtstoff nach einem der Ansprüche 2 bis 5 ist.

7. Lichtemittierende Einrichtung unter Verwendung des lumineszierenden Materials nach Anspruch 6.

## Revendications

1. Procédé de production d'un luminophore β-SiAlON comprenant un β-SALON représenté par la formule générale Si_{6-z}Al_{z}O_{z}N_{8-z} (0 < z < 4,2) en tant que matrice, et Eu²⁺ y étant dissous sous la forme d'une solution solide en tant que centre d'émission, le luminophore β-SiAlON présentant une longueur d'onde de crête fluorescente de 520 à 560 nm lorsque excitée par de la lumière bleue, une réflexion diffuse moyenne de 90 % ou plus dans la plage de longueur d'onde de 700 à 800 nm, et une réflexion diffuse de 85 % ou plus à la longueur d'onde de crête fluorescente, le procédé comprenant :
un processus de cuisson consistant à cuire un mélange de poudre de matière première contenant Si, Al et Eu dans une atmosphère d'azote à des températures de 1 850 à 2 050 °C ;
un processus de chauffage consistant à chauffer le mélange ayant subi le procédé de cuisson dans une atmosphère de gaz noble à des températures de 1 300 à 1 550 °C ;
un processus de refroidissement consistant à refroidir le mélange ayant subi le processus de chauffage à des températures de 1 200 à 1 000 °C pendant une durée de 20 minutes ou plus ; et
un processus de traitement à l'acide.

2. Luminophore β-SiAlON , comprenant : un β-SiAlON représenté par la formule générale Si_{6-z}Al_{z}O_{z}N_{8-z} (0 < z < 4,2) en tant que matrice ; et Eu²⁺ y étant dissous sous la forme d'une solution solide en tant que centre d'émission et produit selon la revendication 1, le luminophore β-SiAlON présentant une longueur d'onde de crête fluorescente de 520 à 560 nm lorsque excitée par de la lumière bleue,
la réflexion diffuse moyenne étant de 90 % ou plus dans la plage de longueur d'onde de 700 à 800 nm, et la réflexion diffuse étant de 85 % ou plus à la longueur d'onde de crête fluorescente.

3. Luminophore β-SiAlON selon la revendication 2, le taux d'Eu étant de 0,1 à 2 % massique.

4. Luminophore β-SiAlON selon la revendication 2 ou 3, l'efficacité quantique interne du luminophore β-SiAlON étant de 77,8 à 82,8 %.

5. Luminophore β-SiAlON selon l'une quelconque des revendications 2 à 4, l'efficacité quantique externe du luminophore β-SiAlON étant de 52,6 à 55,7 %.

6. Matériel luminescent, comprenant : un dispositif émettant de la lumière ; un ou plusieurs types de luminophore β-SiAlON qui absorbe la lumière émise par le dispositif émettant de la lumière et émet de la lumière ayant une longueur d'onde supérieure à celle de la lumière émise par le dispositif émettant de la lumière ; et un matériau d'étanchéité contenant le luminophore β-SiAlON, le luminophore β-SiAlON étant le luminophore β-SiAlON selon l'une quelconque des revendications 2 à 5.

7. Appareil émettant de la lumière utilisant le matériel luminescent selon la revendication 6.
